**Europäisches Patentamt**

**European Patent Office**

**Office européen des brevets**

(19)

(11) Veröffentlichungsnummer: **0 023 943**
**B1**

(12) **EUROPÄISCHE PATENTSCHRIFT**

(45) Veröffentlichungstag der Patentschrift:
**25.01.84**

(51) Int. Cl.³: **H 03 H 11/34**

(21) Anmeldenummer: **80100743.6**

(22) Anmeldetag: **14.02.80**

(54) **Schaltungsanordnung zum Empfangen und Verstärken von Hochfrequenzsignalen.**

(30) Priorität: **11.08.79 DE 2932651**

(43) Veröffentlichungstag der Anmeldung:
**18.02.81 Patentblatt 81/7**

(45) Bekanntmachung des Hinweises auf die Patenterteilung:
**25.01.84 Patentblatt 84/4**

(84) Benannte Vertragsstaaten:
**AT BE DE FR GB IT LU NL SE**

(56) Entgegenhaltungen:
**DE - A - 2 310 616**
**DE - A - 2 553 211**
**US - A - 3 614 628**

(73) Patentinhaber: **ROBERT BOSCH GMBH, Postfach 50,
D-7000 Stuttgart 1 (DE)**

(72) Erfinder: **Becker, Hubert, Uhlandweg 19,
D-3200 Hildesheim (DE)**
Erfinder: **Klinkwitz, Kurt, Boumannstrasse 17 e,
D-1000 Berlin 28 (DE)**

(74) Vertreter: **Schmidt, Hans-Ekhardt, Robert Bosch GmbH
Geschäftsbereich Elektronik Patent- und
Lizenzabteilung Forckenbeckstrasse 9-13,
D-1000 Berlin 33 (DE)**

Schaltungsanordnung zum Empfangen und Verstärken von Hochfrequenzsignalen

*Stand der Technik*

Die Erfindung geht aus von einer Schaltungsanordnung nach der Gattung des Hauptanspruchs.

Es ist schon eine derartige Schaltungsanordnung bekannt (DE-PS 2 310 616), bei der die Hochfrequenzverstärkereinrichtung je einen eigenen Verstärkerzweig für die Signale des unteren und des oberen Empfangsbereiches aufweist.

Es ist weiterhin eine Ankoppelschaltung bekannt (DE-A-2 553 211), mit der die von einer einzigen Antenne herrührenden LMK- und UKW-Signale derart aufgeteilt werden, dass die LMK-Signale unverstärkt und die UKW-Signale mittels eines Verstärkers verstärkt an einen Eingang eines Rundfunkempfängers gelangen. Dabei ist der Verstärkungsweg über einen UKW-Sperrkreis, der für die UKW-Frequenzen wie eine Induktivität wirkt, überbrückt. Aus der genannten Offenlegungsschrift geht nicht hervor, ob der Verstärkereingang mit dem Fusspunkt einer Antenne verbunden ist oder ob — wie es wahrscheinlicher ist — zwischen dem Fusspunkt der Antenne und dem Eingang des Verstärkers bzw. der Ankoppelschaltung noch das für ein Autoradio erforderliche Antennenkabel liegt. Die bekannten Schaltungsanordnungen haben den Nachteil, dass sich bei der Verstärkung von Signalen des oberen Frequenzbereiches, also zum Beispiel des UKW-Bereiches, eine Reihe von unerwünschten Wirkungen ergibt, die dem Fachmann unter den Stichworten Intermodulation, Kreuzmodulation und Euro-Funk-Störung geläufig sind. Ausserdem führt die bei der Verstärkung der Signale des oberen Empfangsfrequenzbereiches auftretende zusätzliche Rauschleistung dazu, dass vorzugsweise beim Empfang mit einem Autoradio das Aufrauschen beim Mehrwegeempfang und bei Abschattung erheblich stört.

Schliesslich ist es bekannt, als Empfangsantenne für beide Empfangsbereiche eine gemeinsame Antenne zu verwenden, deren mechanische Länge erheblich geringer als die halbe Betriebswellenlänge ist. Insbesondere bei Fahrzeugen finden in zunehmendem Masse Antennen in Form eines Wendelstabes von beispielsweise ca. 40 cm Länge Anwendung, deren elektrische Länge durch bekannte Massnahmen vergrössert werden kann.

*Aufgabe der Erfindung*

Der Erfindung liegt die Aufgabe zugrunde, eine Schaltungsanordnung nach dem Oberbegriff des Patentanspruchs 1 zu schaffen, bei der Störungen durch Intermodulation, Kreuzmodulation und Euro-Funk sowie beim UKW-Empfang das Aufrauschen bei Mehrwegeempfang und bei Abschattung vermieden werden.

*Vorteile der Erfindung*

Die erfindungsgemässe Schaltungsanordnung mit den kennzeichnenden Merkmalen des Hauptanspruchs hat den Vorteil, dass trotz Verzichts auf eine Verstärkung der Signale des oberen Frequenzbereiches und gegebenenfalls trotz kurzen Antennenstabes unter normalen Empfangsbedingungen ein einwandfreier Empfang gewährleistet wird.

Die Erfindung geht von der Überlegung aus, dass die Signale des oberen (FM-)Frequenzbereiches ohnehin nur in einem räumlich begrenzten Gebiet empfangen werden können, in welchem sie gewöhnlich mit ausreichender Feldstärke auftreten.

Besonders vorteilhaft ist es, dass ein für die kapazitive Überbrückung des Verstärkers vorgesehener Kondensator als Kopplungskondensator für ein zweikreisiges Bandfilter geschaltet ist, dessen einer Resonanzkreis durch die Antenne gebildet ist und dessen anderer Resonanzkreis als Anpassungskreis für ein an den Ausgang des Hochfrequenzverstärkers anzuschliessendes Kabel ausgebildet ist. Eine derartige Bandfilteranordnung bewirkt eine gewisse Breitbandigkeit, wodurch zum Beispiel der gesamte UKW-Bereich ohne eine zusätzliche Dämpfung an den Bereichsgrenzen optimal angepasst werden kann.

Durch die in den Unteransprüchen aufgeführten Massnahmen sind vorteilhafte Weiterbildungen und Verbesserungen der im Hauptanspruch angegebenen Schaltungsanordnung möglich.

*Zeichnung*

Ausführungsbeispiele der Erfindung sind in der Zeichnung anhand mehrerer Figuren dargestellt und in der nachfolgenden Beschreibung näher erläutert. Die Zeichnung zeigt in

Fig. 1 ein Blockschaltbild einer erfindungsgemässen Schaltungsanordnung in einer ersten Ausführungsform,

Fig. 1a eine alternative Schaltungseinzelheit zu Fig. 1,

Fig. 2 ein Blockschaltbild einer erfindungsgemässen Schaltungsanordnung in einer zweiten Ausführungsform und

Fig. 3 ein vollständiges Schaltbild einer Schaltungsanordnung ähnlich Fig. 2.

*Beschreibung der Erfindung*

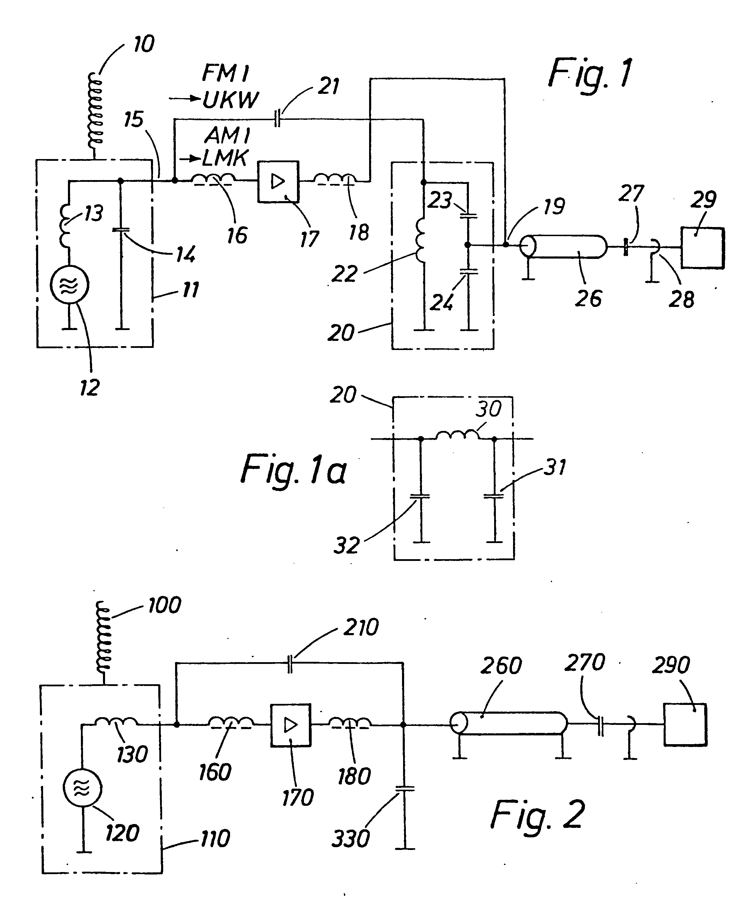

Die in Fig. 1 dargestellte erfindungsgemässe Schaltungsanordnung weist eine Empfangsantenne 10 auf, das ist vorzugsweise eine als Wendelantenne ausgebildet Fahrzeugantenne, deren mechanische Länge kürzer als die Hälfte der Betriebswellenlänge λ in dem oberen Frequenzbereich ist. Ein Ersatzschaltbild 11 dieses Antennenmonopols besteht aus einer Reihenschaltung eines Hochfrequenzgenerators 12 und einer ersten Induktivität 13 sowie einem der Reihenschaltung parallelgeschalteten ersten Kondensator 14.

Der an Induktivität 13 abgewandte Anschluss des Hochfrequenzgenerators liegt auf Massepotential. Der dem Hochfrequenzgenerator abgewandte Anschluss der Induktivität 13 bzw. das heisse Ende des Kondensators 14 bilden einen Anschluss 15, der über eine zweite Induktivität 16 mit dem Eingang eines Hochfrequenzverstärkers 17 für den unteren Frequenzbereich, zum Beispiel für den LMK-Bereich, verbunden ist. An den Ausgang des Hochfrequenzverstärkers 17 schliesst sich eine dritte Induktivität 18 an, die mit einem Eingang 19 eines abgeschirmten Antennenkabels 26 in Verbindung steht. Den Hochfrequenzverstärker 17 überbrückt ein zweiter Kondensator 21, der zwischen dem Anschluss 15 und dem heissen Ende eines Resonanzkreises 20 liegt. Der Resonanzkreis 20 besteht aus einer auf Massepotential liegenden vierten Induktivität 22 und zwei dazu parallelgeschalteten Reihenkondensatoren 23 und 24. Mit einem Abgriff 25 zwischen den beiden Reihenkondensatoren ist der Eingang 19 des abgeschirmten Antennenkabels 26 verbunden, dessen Ausgang über einen dritten Kondensator 27 und einen Steckverbinder 28 mit dem Eingangskreis eines Hochfrequenzempfängers 29, das ist zum Beispiel ein AM/FM-Autoradio, verbunden ist.

Die Wirkungsweise der vorstehend beschriebenen Schaltungsanordnung nach Fig. 1 ist folgende.

Das Ersatzschaltbild 11 der Antenne 10 stellt einen Resonanzkreis dar, der zusammen mit dem Resonanzkreis 20 und dem beide Resonanzkreise koppelnden zweiten Kondensator 21 ein zweikreisiges Bandfilter für die Frequenzen des oberen Frequenzbereiches (UKW-Bereiches) bildet.

Die Fusspunktimpedanz der Antenne 10 liegt beispielsweise zwischen 1 und 10 kΩ, so dass eine gegenüber einer λ/4-Antenne stark erhöhte Signalspannung ansteht. Diese hohe Signalspannung gelangt über den Kondensator 21 an den gleichzeitig zur Anpassung dienenden Resonanzkreis 20, der derart Dimensioniert ist, dass er die Hochpunktimpedanz an die Kabelimpedanz von 150 Ω anpasst.

Der Resonanzkreis 20 kann auch die in Fig. 1a gezeigte Konfiguration aufweisen, bei der die Signalwechselspannung zwischen einer fünfen Induktivität 30 und einem mit dieser Induktivität in Reihe geschalteten vierten Kondensator 31 abgegriffen wird. Die Reihenschaltung aus der fünften Induktivität 30 und dem vierten Kondensator 31 liegt parallel zu einem fünften Kondensator 32.

Das Bandfilter mit den Resonanzkreisen nach Fig. 1 oder 1a ist derart breitbandig, dass der gesamte obere Frequenzbereich (UKW-Bereich) ohne Zusatzdämpfung an den Bereichsgrenzen optimal angepasst werden kann. Die Induktivitäten 16 und 18 am Eingang bzw. Ausgang des Verstärkers 17 für den unteren Frequenzbereich sind Drosseln, die die Signalfrequenzen des oberen Frequenzbereiches vom Verstärkereingang und -ausgang fernhalten und im wesentlichen nur die Signalfrequenzen des unteren Frequenzbereiches durchlassen.

Da sich die Schaltungsanordnung nach den Fig. 1 bus 1a in dem oberen Frequenzbereich völlig passiv verhält, können auch die Eigenschaften des nachgeschalteten Hochfrequenzempfängers 29 nicht nachteilig beeinflusst werden. Andererseits wird die Verstärkung der Frequenzen des unteren Frequenzbereiches nicht durch die kapazitive Überbrückung des Hochfrequenzverstärkers beeinflusst, wenn der Verstärker eine Verstärkung von annähernd 1 und eine Phasenverschiebung $\phi$ von etwa 0° hat. Dann fliesst nämlich kein Strom über den Kondensator 21, und es tritt keine Belastung der Antenne durch den überbrückten Verstärker auf.

Eine Alternative zu der Schaltungsanordnung nach den Fig. 1 und 1a ist in Fig. 2 gezeigt.

In dieser Schaltungsanordnung ist die Antenne 100 so bemessen, dass sie im oberen Frequenzbereich unterhalb ihrer Parallelresonanzfrequenz schwingt und somit eine induktive Charakteristik aufweist; vgl. Induktivität 130. Das Ersatzschaltbild 110 der Antenne besteht in diesem Falle aus einem Hochfrequenzgenerator 120 in Serie mit der Induktivität 130. Die zuletzt genannte Induktivität bildet zusammen mit dem Kondensator 210 zur Überbrückung des Hochfrequenzverstärkers 170 und mit einem Kondensator 330 einen Parallelresonanzkreis. Zur Anpassung des Hochfrequenzverstärkers an das Antennenkabel 260 dient ein kapazitiver Spannungsteiler aus den Kondensatoren 210 und 330. Die Induktivitäten 160 und 180 brauchen bei der Dimensionierung des Parallelresonanzkreises aus der Induktivität 130 und den Kondensatoren 210 und 330 nicht berücksichtigt zu werden, weil sich ihre Wirkung beim Abstimmen des Kreises kompensieren lässt. An die Stelle eines Bandfilters nach der Schaltungsanordnung gemäss Fig. 1 tritt also in dem Ausführungsbeispiel nach Fig. 2 ein auf die Mittenfrequenz des oberen Frequenzbereiches abgestimmter Parallelresonanzkreis. Das Ausführungsbeispiel nach Fig. 2 weist gegenüber dem Beispiel nach Fig. 1 verschiedene Vorteile auf, wozu im wesentlichen eine geringere Bauelementenzahl, ein geringerer Platzbedarf, eine kürzere Drahtlänge der Wendelantenne oder — bei einer Stabantenne — eine kürzere elektrische Länge sowie geringere Weichenverluste gehören.

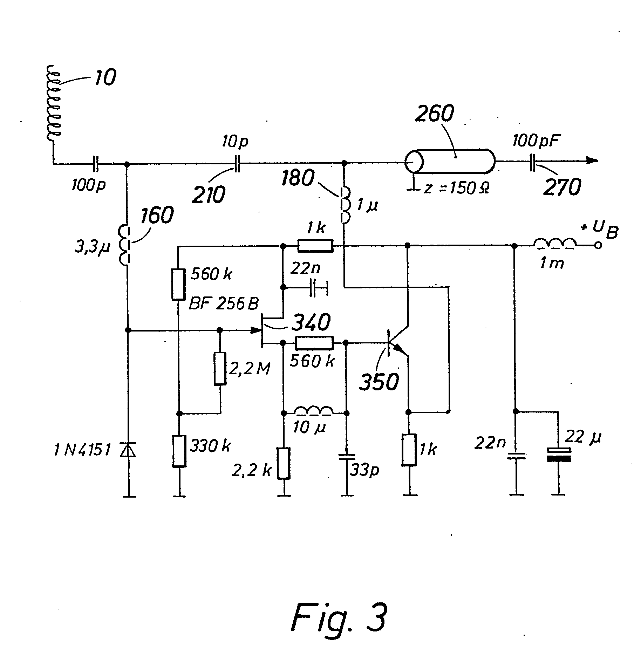

Die Fig. 3 zeigt ein vollständiges Schaltbild einer Schaltungsanordnung ähnlich der nach Fig. 2. In dieser Figur sind der Fig. 2 entsprechende Bauelemente mit denselben Bezugszahlen versehen. An die Stelle des Parallelresonanzkreises nach Fig. 2 tritt hier ein Serienresonanzkreis aus der Antenneninduktivität und dem Kondensator 210.

Der Hochfrequenzverstärker 170 (Fig. 2) für den unteren Frequenzbereich enthält nach Fig. 3 als aktive Bauelemente einen Feldeffekttransistor 340 und einen bipolaren Transistor 350 in Emitter- bzw. Sourcefolgerschaltung. Eine praktisch erprobte Schaltung weist die aus Fig. 3 ersichtliche Dimensionierung der Bauelemente auf.

Für alle vorstehend beschriebenen Schaltungsanordnungen ist es auch möglich, als Antenne eine Stabantenne zu verwenden, deren mechanische Länge $\ell = 100 \ldots 300$ cm beträgt. Für die Ausführungsbeispiele gemäss den Fig. 2 und 3 würde sich besonders eine 1-m-Stabantenne eignen.

Während bei der Schaltungsanordnung nach Fig. 1 für die Überbrückung des Hochfrequenzverstärkers ein Bandfilter-Netzwerk vorgesehen ist — dadurch werden die Breitbandigkeit und die Störsicherheit gegenüber Fernsehsendern verbessert —, weisen die Schaltungsanordnungen nach den Fig. 2 und 3 nur einen Parallel- bzw. Serienresonanzkreis im Umgehungsweg des Verstärkers auf. Damit auch bei diesen Schaltungsanordnungen die gewünschte Bandfiltercharakteristik erzielt wird, soll das Antennenkabel 260 eine Länge $\ell = n \cdot \frac{\lambda}{2} + \frac{\lambda}{4}$ oder $\ell = n \cdot \frac{\lambda}{2}$ aufweisen, wobei n eine ganze Zahl und $\lambda$ die Betriebswellenlänge des oberen Frequenzbereiches bedeuten. Ist der obere Frequenzbereich der FM/ UKW-Rundfunkbereich, so sollte das Antennenkabel bei einer Schaltungsanordnung nach Fig. 3 vorzugsweise eine Länge von zweimal $\frac{\lambda}{2}$ gleich $\lambda$ haben, da sich diese Leitungslänge bei einem praktischen Schaltungsaufbau besonders bewährt hat.

Die Wirkung eines an den Serienresonanzkreis (Fig. 3) im Umgehungsweg des Verstärkers angeschlossenen Kabels ist in Verbindung mit dem Antennenkabel derart, dass sich bei der Betriebswellenlänge am Eingang des Autoradios ein reeller Widerstandswert ergibt. Abweichungen von der Betriebswellenlänge, das ist die mittlere Wellenlänge des oberen Frequenzbereiches, führen zu einer Schleifenbildung im Smith-Diagramm um den Mittelpunkt 1. Verschiebt man die Schleife durch eine entsprechende Dimensionierung des Serienresonanzkreises derart, dass die Anpassung in der Mitte der Schleife (zum Beispiel bei 150 Ω) liegt, so ist der Abstand der entstehenden Ortskurve der Ausgangsimpedanz des Kabels vom Mittelpunkt über einen grösseren Frequenzbereich annähernd konstant. Dadurch bleibt die Fehlanpassung an den Eingangskreis des Autoradios ebenfalls annähernd konstant.

Die Selektionskurve der Antenne hat dann nicht mehr die bekannte Resonanzkreis-Charakteristik, sondern eine an der Kurvenspitze abgeflachte Charakteristik, die durch ein Verschieben der Kurve auch zu einer zweihöckrigen Bandfilterkurve umgeformt werden kann.

Hat das Kabel eine Leitungslänge $\ell = n \cdot \frac{\lambda}{2}$ mit $n > 2$, dann weist das Smith-Diagramm eine den Mittelpunkt mehrfach umrundende Schleife auf.

Analoge Wirkungen treten bei dem Parallelresonanzkreis entsprechend der Schaltungsanordnung nach Fig. 2 auf. Bei dieser Schaltungsanordnung findet vorzugsweise ein Antennenkabel der Länge $\ell = n \cdot \frac{\lambda}{2} + \frac{\lambda}{4}$ Anwendung.

**Patentansprüche**

1. Schaltungsanordnung zum Empfangen und Verstärken von Hochfrequenzsignalen eines unteren und eines oberen Empfangsfrequenzbereiches, insbesondere des AM/LMK-Rundfunkbereiches und des FM/UKW-Rundfunkbereiches, mit einer für beide Frequenzbereiches gemeinsamen Antenne, deren mechanische Länge sehr kurz gegenüber der Betriebswellenlänge des unteren Empfangsfrequenzbereiches ist, und mit einer mit dem Fusspunkt der Antenne verbundenen Hochfrequenzverstärkereinrichtung, gekennzeichnet durch einen im wesentlichen nur die Hochfrequenzsignale des unteren Frequenzbereiches verstärkenden Hochfrequenzverstärker (17), der für die Hochfrequenzsignale des oberen Frequenzbereiches durch einen Kondensator (21) überbrückt ist, der Bestandteil eines Einzelresonanzkreises (130, 210, 330) oder Kopplungskondensator (21, 210) zweier ein Bandfilter bildender Resonanzkreise (13, 14; 22, 23, 24) ist, wobei Einzelresonanzkreis und Bandfilter auf den oberen Frequenzbereich abgestimmt sind, die Antenne (10, 100) eine Induktivität (130) für den Einzelresonanzkreis oder eine Induktivität (13) und eine Kapazität (14) für den ersten der beiden Resonanzkreise des Bandfilters bildet und wobei der Einzelresonanzkreis bzw. der Ausgangskreis des Bandfilters an das anzuschliessende Antennenkabel (26, 260) angepasst ist.

2. Schaltungsanordnung nach Anspruch 1, dadurch gekennzeichnet, dass der Hochfrequenzverstärker (17) eine Verstärkung von annähernd 1 und eine Phasendrehung $\phi$ von etwa 0° aufweist.

3. Schaltungsanordnung nach Anspruch 1, dadurch gekennzeichnet, dass die Länge der Antenne (100) derart bemessen ist, dass sie im oberen Frequenzbereich wie eine Induktivität (130) wirkt, die zusammen mit einem den Hochfrequenzverstärker (170) überbrückenden Kondensator (210) und einem mit diesem Kondensator in Reihe liegenden, mit Masse verbundenen weiteren Kondensator (330) einen Parallelresonanzkreis bildet, und dass zwischen den beiden Kondensatoren (210, 330) das Antennenkabel (260) angeschlossen ist.

4. Schaltungsanordnung nach Anspruch 1, dadurch gekennzeichnet, dass der Resonanzkreis (20) aus einer Induktivität (22) und einer parallel dazu liegenden Reihenschaltung aus zwei Kondensatoren (23, 24) besteht und dass ein Abgriff (25) zwischen den beiden Kondensatoren (23, 24) einen Anschluss für ein Antennenkabel (26) und den Verstärkerausgang bildet.

5. Schaltungsanordnung nach Anspruch 1, dadurch gekennzeichnet, dass der Resonanzkreis aus einem Kondensator (32) und einer parallel dazu liegenden Reihenschaltung aus einer Induktivität (30) und einem Kondensator (31) besteht und dass ein Abgriff zwischen der Induktivität (30) und dem Kondensator (31) als Anschluss für das Antennenkabel (26) dient.

6. Schaltungsanordnung nach Anspruch 1, dadurch gekennzeichnet, dass die Induktivität der Antenne (10) zusammen mit einem den Hochfrequenzverstärker überbrückenden Kondensator (210) einen Serienresonanzkreis bildet.

7. Schaltungsanordnung nach einem der Ansprüche 1 bis 6, dadurch gekennzeichnet, dass der Hochfrequenzverstärker (17, 170) eingangsseitig und ausgangsseitig je eine Hochfrequenzdrossel (160, 180) aufweist, die im wesentlichen nur die Frequenzen des unteren Frequenzbereiches durchlässt.

8. Schaltungsanordnung nach Anspruch 1 oder 6, dadurch gekennzeichnet, dass das Antennenkabel (26, 260) eine Länge $\ell = n \cdot \frac{\lambda}{2}$ hat, wobei n eine ganze Zahl und $\lambda$ die Betriebswellenlänge ist.

9. Schaltungsanordnung nach Anspruch 1 oder 3, dadurch gekennzeichnet, dass das Antennenkabel (260) eine Länge $\ell = n \cdot \frac{\lambda}{2} + \frac{\lambda}{4}$ hat, wobei n eine ganze Zahl und $\lambda$ die Betriebswellenlänge ist.

10. Schaltungsanordnung nach einem der Ansprüche 1 bis 7, dadurch gekennzeichnet, dass die Antenne (10) aus einem wendelförmig gewickelten Draht besteht.

**Claims**

1. A circuit arrangement for the reception and amplification of high frequency signals of a lower and an upper reception frequency range, particularly the AM/LMS radio range and the FM/VHF radio range, having an antenna which is common to the two frequency ranges and whose mechanical length is very short compared with the operating wave length of the lower reception frequency range, and a high-frequency amplifier means which is connected to the foot of the antenna, characterised by a high-frequency amplifier (17) which amplifies substantially only the high-frequency signals of the lower frequency range and which is by-passed for the high-frequency signals of the upper frequency range by means of a capacitor (21) which is a component part of a single resonant circuit (130, 210, 330) or by a capacitor (21, 210) which couples two resonant circuits (13, 14; 22, 23, 24) forming a band pass filter, the single resonant circuit and the band pass filter being tuned to the upper frequency range, the antenna (10, 100) forming an inductance (130) for the single resonant circuit or an inductance (13) and a capacitor (14) for the first of the two resonant circuits of the band pass filter, and the single resonant circuit or the output circuit of the band pass filter being matched to the antenna cable (26, 260) to be connected.

2. A circuit arrangement as claimed in claim 1, characterised in that the high-frequency amplifier (17) has an amplification of approximately 1 and a phase shift $\phi$ of approximately $0°$.

3. A circuit arrangement as claimed in claim 1, characterised in that the length of the antenna (100) is dimensioned such that, in the upper frequency range, it acts like an inductance (130) which forms a parallel resonant circuit together with a capacitor (210) by-passing the high-frequency amplifier (170) and a further capacitor (330) which is connected in series with the firstmentioned capacitor and to earth, and that the antenna cable (260) is connected between the two capacitors (210, 330).

4. A circuit arrangement as claimed in claim 1, characterised in that the resonant circuit (20) comprises an inductor (22) and a series combination which is connected in parallel therewith and which comprises two capacitors (23, 24), and that a tapping (25) between the two capacitors (23, 24) forms a terminal for an antenna cable (26) and the amplifier output.

5. A circuit arrangement as claimed in claim 1, characterised in that the resonant circuit comprises a capacitor (32) and a series combination which is connected in parallel therewith and which comprises an inductor (30) and a capacitor (31), and that a tapping between the inductor (30) and the capacitor (31) serves as a terminal for the antenna cable (26).

6. A circuit arrangement as claimed in claim 1, characterised in that the inductance of the antenna (10) forms a series resonant circuit together with a capacitor (210) which by-passes the high-frequency amplifier.

7. A circuit arrangement as claimed in any one of the claims 1 to 6, characterised in that the input side and the output side of the high-frequency amplifier (17, 170) each has a respective high-frequency choke coil (160, 180) which transmits substantially only the frequencies of the lower frequency range.

8. A circuit arrangement as claimed in claim 1 or 6, characterised in that the antenna cable (26, 260) has a length $\ell = n \cdot \dfrac{\lambda}{2}$, $\underline{n}$ being an integer and $\lambda$ being the operating wave length.

9. A circuit arrangement as claimed in claim 1 or 3, characterised in that the antenna cable (260) has a length $\ell = n \cdot \dfrac{\lambda}{2} + \dfrac{\lambda}{4}$, $\underline{n}$ being an integer and $\lambda$ being the operating wave length.

10. A circuit arrangement as claimed in any one of the claims 1 to 7, characterised in that the antenna (10) comprises a helically coiled wire.

**Revendications**

1. Montage pour la réception et l'amplification de signaux haute fréquence dans une plage de fréquences, inférieure ou supérieure, notamment dans la plage d'émission radio AM-LMC et la plage FM-OTC, avec une antenne commune pour les deux plages de fréquences, antenne dont la longueur mécanique est très courte par rapport à la longueur d'onde de fonctionnement de la plage de réception inférieure, et avec une installation d'amplification haute fréquence reliée à la base de l'antenne, caractérisé par un amplificateur haute fréquence (17) qui n'amplifie principalement que les signaux haute fréquence de la plage inférieure de fréquences, et qui est dérivé par un condensateur (21) pour les signaux haute fréquence de la plage des fréquences supérieures, condensateur qui fait partie d'un circuit résonnant séparé (130, 210, 330) ou d'un condensateur de couplage (21, 210) de deux circuits résonnants (13, 14; 22, 23, 24) formant un filtre passe-bande, le circuit résonnant séparé et le filtre passe-bande étant accordés sur la plage des fréquences supérieures, l'antenne (10, 100) constituant une inductance (130) pour le circuit résonnant séparé ou une inductance (13) et une capacité (14) pour le premier des deux circuits résonnants du filtre passe-bande, le circuit résonnant séparé ou le circuit de sortie du filtre passe-bande étant adapté au câble d'antenne à raccorder (26, 260).

2. Montage selon la revendication 1, caractérisé en ce que l'amplificateur haute fréquence (17) assure une amplification voisine de 1 et un déphasage $\phi$ sensiblement égal à $0°$.

3. Montage selon la revendication 1, caractérisé en ce que la longueur de l'antenne (100) est dimensionnée de façon à fonctionner comme une inductance (130) dans la plage des fréquences supérieures, inductance qui, avec le condensateur (210) dérivant l'amplificateur haute fréquence (170) et un autre condensateur (330) en série avec le précédent et relié à la masse, formant un circuit résonnant parallèle et en ce que le câble d'antenne (260) est branché entre les deux condensateurs (210, 330).

4. Montage selon la revendication 1, caractérisé en ce que le circuit résonnant (20) se compose d'une inductance (22) et d'un montage en série formé de deux condensateurs (23, 24), lui-même en parallèle au précédent, et en ce que la borne (25) entre les deux condensateurs (23, 24) forme le raccordement d'un câble d'antenne (26) et de la sortie de l'amplificateur.

5. Montage selon la revendication 1, caractérisé en ce que le circuit résonnant est formé d'un condensateur (32) et en parallèle à celui-ci un montage en série formé d'une inductance (30) et d'un condensateur (31) et la borne entre l'inductance (30) et le condensateur (31) constitue le raccordement du câble d'antenne (26).

6. Montage selon la revendication 1, caractérisé en ce que l'inductance de l'antenne (10) forme un circuit résonnant en série avec le condensateur (210) en dérivation sur l'amplificateur haute fréquence.

7. Montage selon l'une des revendications 1 à 6, caractérisé en ce que l'amplificateur haute fréquence (17, 170) présente une bobine d'arrêt haute fréquence (160, 180) respectivement à l'entrée et à la sortie, bobines qui ne laissent principalement passer que les fréquences de la plage des fréquences inférieures.

8. Montage selon la revendication 1 ou 6, caractérisé en ce que le câble d'antenne (26, 260) a une longueur $\ell = n \cdot \dfrac{\lambda}{2}$, n étant un nombre entier et $\lambda$ la longueur d'onde de fonctionnement.

9. Montage selon la revendication 1 ou 3, caractérisé en ce que le câble d'antenne (260) a une longueur $\ell = n \cdot \dfrac{\lambda}{2} + \dfrac{\lambda}{4}$, n étant un nombre entier et $\lambda$ la longueur d'onde de fonctionnement.

10. Montage selon l'une des revendications 1 à 7, caractérisé en ce que l'antenne (10) est un fil enroulé de façon hélicoïdale.

Fig. 1

Fig. 1a

Fig. 2

Fig. 3